# EUROPEAN PATENT APPLICATION

(11) **EP 2 131 501 A1**
(43) Date of publication of application: **09.12.2009**
(21) Application number: 08010349.2
(22) Date of filing: 06.06.2008
(51) Int. Cl.: H03M 7/46

(54) **Data compression and decompression method and data processing apparatus**

(71) Applicant: Harman Becker Automotive Systems GmbH, 76307 Karlsbad (DE)
(72) Inventor: Richert, Arwed, 72768 Reutligen (DE)
(74) Representative: Bertsch, Florian Oliver

(57) **Abstract**

A data compression and decompression method and a data processing apparatus are provided. In a data compression method, data is retrieved from a data block (160). A packet type is selected from a plurality of packet types based on whether the data includes a predetermined number of repetitions of a data sequence (169). A data packet (171-173, 191) is generated from the data, the data packet (171-173, 191) including control information (174, 175a, 175c, 176, 177a, 177c, 178) set based on the packet type and size information (174, 175b, 177b) set based on a storage space containing the control information (174, 175a, 175c, 176, 177a, 177c, 178).

## Description

The present invention relates to a data compression and decompression method and a data processing apparatus. In particular, the present invention relates to a data compression and decompression method and a data processing apparatus that may be used to compress and decompress data for use in human-machine interfaces, for example in a navigation device.

### Related Art

An increasing number of electronic systems in various fields of applications provides optical, acoustic, tactile or other output to a user via a human-machine interface, such as via a display or loudspeaker. An enhanced output quality of output devices, for example a higher resolution of optical displays, in combination with increasing computational power of processors which process the data to be output allows high-quality output to be provided to users of an electronic system.

The growing demand for high-quality data output in electronic applications has also led to a continuous increase in the amount of data to be stored for output to a user and, correspondingly, to increasing storage space requirements. While data compression and decompression techniques may be employed to address the problem of increasing storage space requirements, a significant reduction of storage space usually requires an efficient data compression technique. Performing the corresponding data decompression may be costly in terms of time and computational resources.

However, many applications, for example in the field of human-machine interfaces, require rapid decompression of data retrieved from a digital data archive in order to provide for a positive user experience.

### Summary

Therefore, there is a need in the art for improved data compression and decompression methods and an improved data processing apparatus. In particular, there is a need in the art for a method and apparatus that provides efficient data compression, thereby reducing storage space requirements, while allowing compressed data to be decompressed in a time-efficient manner.

According to the present invention, this need is addressed by a method and apparatus as defined in the independent claims. The dependent claims define preferred or advantageous embodiments of the invention.

According to one aspect of the present invention, a data compression method is provided which comprises retrieving data from a data block to be compressed, determining whether the data includes a predetermined number of repetitions of a data sequence, and selecting a packet type from a plurality of packet types for said data based on said determining. A data packet is generated from the data, which includes control information and size information set based on a storage space containing the control information. The control information is set based on the selected packet type.

The control information may, for example, include one or several control bits indicating one of the plurality of packet types, and a counter value indicating a number of bytes of payload data included in the data packet or similar, depending on the packet type. As the data packet is generated so as to include the size information, the storage space in which the control information is stored may be adjusted based on the amount of control information. For example, the size information may be a bit indicating whether the control information is stored in one or two bytes.

The data compression method may be a run length encoding method. In the data compression method, the number of control bytes of a generated data packet may be variable.

The data compression method may be a run length encoding method in which data packets including at least one control byte are generated also when the data does not include the predetermined number of repetitions of a data sequence.

The packet type may be selected from a first packet type and a second packet type. The first packet type may be selected when the data does not include the predetermined number of repetitions of a data sequence. Then, the data itself is included in the data packet, and the control information is set to include information on a data amount of the data. For example, the control information may comprise a counter value indicating the number of bytes of the data that is written into the data packet. Depending on the counter value, the counter value may be stored in one or several bytes of the data packet, as indicated by the size information. As the data packet having the first packet type includes control information indicative of a data amount of the data and, correspondingly, a size of the data packet, the size of the data packet having the first packet type may be variable. Therefore, data alignment, e.g., line alignment of image data, may be achieved.

The second packet type may be selected when the data includes the predetermined number of repetitions of a data sequence. Then, the data sequence is included in the data packet, and the control information is set such that it includes information on the number of times the data sequence is successively repeated in the original data. For example, the control information may include a counter value indicating the number of successive repetitions of the data sequence in the original data. Depending on the counter value, the counter value may be stored in one or several bytes of the data packet, as indicated by the size information.

As data packets, although of different packet types, may be generated both when the data includes the predetermined number of repetitions of a data sequence and when the data does not include the predetermined number of repetitions of the data sequence, the data packets may be decompressed efficiently.

The data packet may include at least one control byte in which both the control information and the size information is stored. In this case, the size information is set based on a number of control bytes. For example, if there is either one or two control bytes in each data packet, the size information may be a single bit value indicating the number of control bytes in the respective data packet. At least one byte of the at least one control byte may store both the size information and at least part of the control information.

A length of the data sequence may be set as a constraint when generating data packets, and a total data amount of data packets generated from the data block may be monitored. For example, the method may be performed sequentially for a data sequence length of one byte, two bytes, three bytes, and four bytes. For generating a data archive, the length of the data sequence may be selected such the total data amount of the generated data packets becomes minimum. Thereby, efficient data compression may be achieved.

The method may also comprise encoding integer values included in the data block prior to retrieving the data. The encoding may be performed such that a number of bytes in which the integer value is encoded is adapted based on the integer value. For example, when a predetermined number of bytes is reserved for every integer value in the original data block irrespective of its numerical value, the integer value may be encoded by truncating bytes which include only bits having value 0. To indicate the number of bytes in which the integer value is encoded, at least one control bit of at least one byte in which the integer value is encoded may be set based on the number of bytes.

The data block may comprise data for use in a human-machine interface, such as image data or audio data to be output to a user. In particular, the data block may comprise bitmap data.

The generated data packet may be stored in a digital data archive for subsequent use in, e.g., a navigation device of a vehicle.

According to another aspect of the invention, a data decompression method is provided, which comprises retrieving a data packet having one of a plurality of possible packet types and including control information and size information. The size information is retrieved from the data packet. The control information is retrieved from a portion of the data packet which is determined based on the size information, and decompressed data is generated from the data packet based on the control information. The data decompression method allows data packets to be decompressed even when the data packets may have different packet types and include a portion of control information having variable size, e.g., one or two bytes of control information. As the size information specifies a portion of the data packet from which the control information may be retrieved, it is possible to distinguish the control information from payload data included in the data packet.

In order to generate the decompressed data, the method may comprise copying data from the data packet. The data that is copied from the data packet to the decompressed data may be copied once or plural times, depending on the packet type. For example, when the data packet has a first packet type, the data from the data packet is copied once to the decompressed data, while, when the data packet has a second packet type, the data from the data packet is copied several times to the decompressed data. In the latter case, the control information of the data packet may include information on the number of copies that is to be included in the decompressed data. Thereby, the decompressed data may be generated based on the control information of the respective data packet.

The data packet may be run length encoded. In particular, the data packet may be such that it is generated by the data compression method according to any one aspect or embodiment of the invention.

The amount of payload data included in the data packet may be determined based on the control information. For example, when the data packet has the first packet type, the control information of the data packet may include a counter value that indicates a number of bytes of payload data comprised by the data packet.

The data packet may include at least one control byte which comprises the control information and the size information, the latter indicating a number of bytes of the at least one control byte. For example, if there are either one or two control bytes in each data packet, the size information may be a single bit value indicating the number of control bytes in the respective packet. At least one byte of the at least one control byte may store both the size information and at least part of the control information.

The method may further comprise decoding an encoded integer value that is included in the decompressed data. The decoding may be based on at least one control bit of at least one byte storing the encoded integer value, the at least one control bit indicating a number of bytes of the at least one byte. Thereby, an integer value may be decoded which is stored in a number of bytes adapted to the integer value, e.g., by reinserting bytes which include only bits having value 0 and by removing control bits.

The integer value may be comprised by header information of image data.

The data packet may be retrieved from a digital data archive for use in a human-machine interface. In particular, the digital data archive may be configured for use in a navigation device onboard a vehicle. The digital data archive may comprise compressed bitmap data.

According to another aspect of the invention, a data processing apparatus is provided, which comprises a digital data archive storing a data packet which includes control information and size information, and a processor coupled to the digital data archive to retrieve the data packet from the digital data archive. The processor is configured to retrieve the control information from a portion of the data packet which is determined based on the size information and to generate decompressed data from the data packet based on the control information. A thus configured data processing apparatus may be used to perform the data decompression method according to any one aspect or embodiment of the present invention.

The digital data archive may be an archive of compressed image data. In particular, the digital data archive may comprise compressed bitmap data.

According to another aspect of the invention, a navigation device is provided, which comprises the data processing apparatus according to any one aspect or embodiment of the invention, and an output device coupled to the processor of the data processing apparatus to receive the decompressed data therefrom and to generate an output signal based on the decompressed data.

In one exemplary embodiment, the output device may be an optical output device, such as a display or a video projector, the decompressed data being image data, for example bitmap data. In another exemplary embodiment, the output device may be an acoustic output device.

The methods and apparatuses according to the various aspects and embodiments of the invention may be utilized in all fields of application in which data compression and decompression is desired. It is anticipated that human-machine interfaces, e.g., of a navigation device installed in a vehicle, are one field of application. However, the present invention is not limited to this specific application.

### Brief Description of the Drawings

The invention will now be described in more detail with reference to the accompanying drawing.
Fig. 1 is a block diagram representation of a data processing apparatus for data compression.
Fig. 2 is a flow diagram representation of a data compression method.
Fig. 3 is a flow diagram representation of a data compression method.
Fig. 4 is a schematic representation of data, Fig. 4A showing data to be compressed, and Figs. 4B and 4C respectively showing data packets generated from the data of Fig. 4A.
Fig. 5 is a schematic representation of data, Fig. 5A showing data to be compressed, and Figs. 5B and 5C respectively showing data packets generated from the data of Fig. 5A.
Fig. 6 is a schematic representation of data, Fig. 6A showing data to be compressed, and Figs. 6B and 6C respectively showing data packets generated from the data of Fig. 6A.
Fig. 7 is a flow diagram representation of a data compression method.
Fig. 8 is a flow diagram representation of a data compression method.
Fig. 9 is a block diagram representation of a navigation device.
Fig. 10 is a flow diagram representation of a data decompression method
Fig. 11 is a flow diagram representation of a data decompression method.

### Detailed Description of Preferred Embodiments

Hereinafter, exemplary embodiments of the invention will be described with reference to the drawings. It is to be understood that the present invention is not limited to the specific embodiments described herein and that, unless explicitly stated otherwise, features of the various embodiments may be combined with each other.

According to embodiments of the invention, methods and apparatuses for data compression and decompression are provided that allow compressed data to be generated from data to be compressed, and decompressed data to be generated from compressed data. As used herein, the term "compressed data" refers to data output by a data compression method, it being understood that a data amount of the "compressed data" may and frequently will, but does not always have to be smaller than the data amount of the corresponding original data. Similarly, the term "decompressed data" as used herein refers to data output by a data decompression method, it being understood that a data amount of the "decompressed data" may and frequently will, but does not always have to be larger than the data amount of the corresponding compressed data.

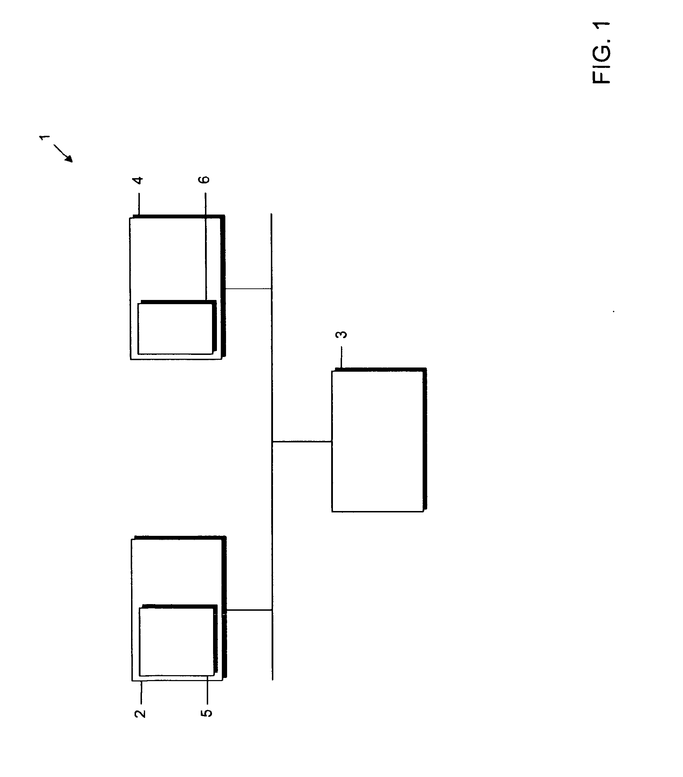

Fig. 1 is a schematic block diagram representation of a data processing apparatus 1 for data compression which comprises a first storage device 2, a processor 3 and a second storage device 4 which, although shown separately from the first storage device 2, may also be formed integrally with the first storage device 2. The processor 3 retrieves data from a data block 5 stored in the first storage device 2, generates a data packet from the data, and stores the generated data packet in the second storage device 4 to thereby generate a digital data archive 6 of compressed data. As used herein, the term "data block" refers to any collection or set of data from which data may be retrieved, without implying any limitation on the size or organization of the data in the data block. Similarly, the term "digital data archive" refers to a collection or set of data generated by a data compression method. The data processing apparatus 1 may be a general-purpose computer, the processor 3 being suitably configured to perform a data compression method according to any one of the embodiments described herein.

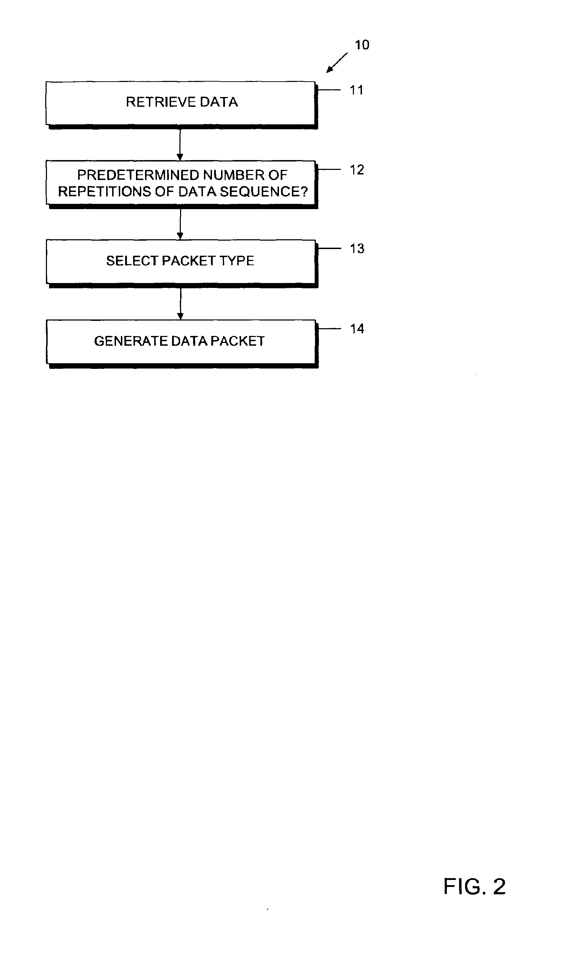

Fig. 2 is a flow diagram representation of a data compression method 10 according to an embodiment. The method may be performed, for example, by the processor 3 of the data processing apparatus 1 of Fig. 1. At 11, data is retrieved from a data block. At 12, it is determined whether the retrieved data includes a predetermined number of repetitions of a data sequence. At 13, a packet type is selected based on a result of the determining. For example, data packets may have a first packet type or a second packet type, and the first packet type is selected when the data does not include the predetermined number of repetitions of a data sequence, while the second packet type is selected otherwise. At 14, a data packet is generated from the retrieved data. The data packet is generated such that it comprises control information set based on the selected packet type and size information set based on a storage space containing the control information. Subsequently, the generated data packet may be stored in a digital data archive or may be output.

As will be explained in more detail below, the data packets generated at 14 may comprise control information, size information, and payload data. Both the control information and the payload data may be dependent on the specific packet type selected at 13. For example, the control information may include an indicator for the packet type of the respective data packet. The control information may also comprise a counter value which, for one packet type, indicates an amount of payload data included in the data packet and, for another packet type, indicates how often a data sequence stored in the data packet is found in the original data. The payload data may be a copy of the retrieved data for one packet type, and may be a data sequence that is successively repeated in the retrieved data for another packet type.

In the method 10, constraints may be imposed on the length of the data sequence, and the predetermined number of repetitions may be a fixed value or may be a value that is adjusted based on the constraints on the length of the data sequence. For example, it may be determined whether the data includes a data sequence of length one byte, two bytes, three bytes, or four bytes that is successively repeated. The predetermined number of repetitions may be set to be smaller when the length of the data sequence is set to be longer.

Although not shown in Fig. 2, steps 11-14 may be repeated until all data has been retrieved from the data block, when required. I.e., by repeating steps 11-14, a plurality of data packets may be generated from the data block in order to generate the digital data archive.

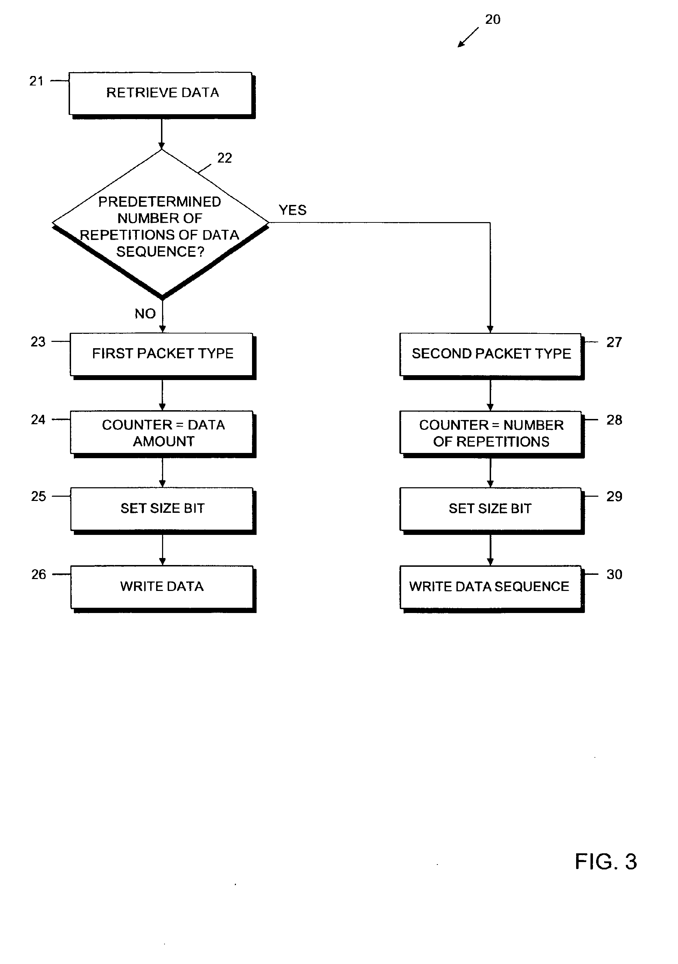

Fig. 3 is a flow diagram representation of a data compression method 20 which is essentially based on the method 10 of Fig. 2, but in which a specific implementation of the selection of a data packet type and the generation of a data packet is illustrated. In the specific implementation of Fig. 3, the control information comprises a counter value, and the size information comprises a size bit having a value of 0 or 1 set based on the counter value.

At 21, data is retrieved from a data block, and at 22 it is determined whether the retrieved data includes a predetermined number of repetitions of a data sequence, as has been explained with reference to steps 11 and 12 of the method 10 above. If the data does not include the predetermined number of repetitions of a data sequence, the method 20 proceeds to steps 23-26. At 23, a first packet type is selected. At 24, the counter value is set equal to the data amount of the retrieved data. For example, the counter value may be the number of bytes of the retrieved data. At 25, the size bit is set based on the storage space required to store the control information. For example, if the counter value is so large that the control information and the size information cannot be stored in a single control byte of the generated data packet, the value of the size bit is set to 1, while the value of the size bit is set to 0 when the counter value is sufficiently small that the control information and the size information can be stored in a single byte. At 26, a copy of the data retrieved at 21 is written into the data packet.

If, at 22, it is determined that the data includes the predetermined number of repetitions of a data sequence, the method 20 proceeds to steps 27-30. At 27, a second packet type is selected. At 28, the counter value is set equal to the number of repetitions of the data sequence in the data retrieved at 21. At 29, the size bit is set based on the storage space required to store the control information. For example, if the counter value is so large that the control information and the size information cannot be stored in a single control byte of the generated data packet, the value of the size bit is set to 1, while the value of the size bit is set to 0 when the counter value is sufficiently small that the control information and the size information can be stored in a single byte. At 30, a copy of the data sequence, rather than the original data, is written into the data packet. Thereby, data compression may be achieved.

When required, the method 20 may be repeated until all data of the data block has been retrieved and converted to data packets. Further, as has already been explained with reference to Fig. 2 above, constraints may be imposed, e.g., on the length of the data sequence, and the predetermined number of repetitions may be adjusted based on the length of the data sequence.

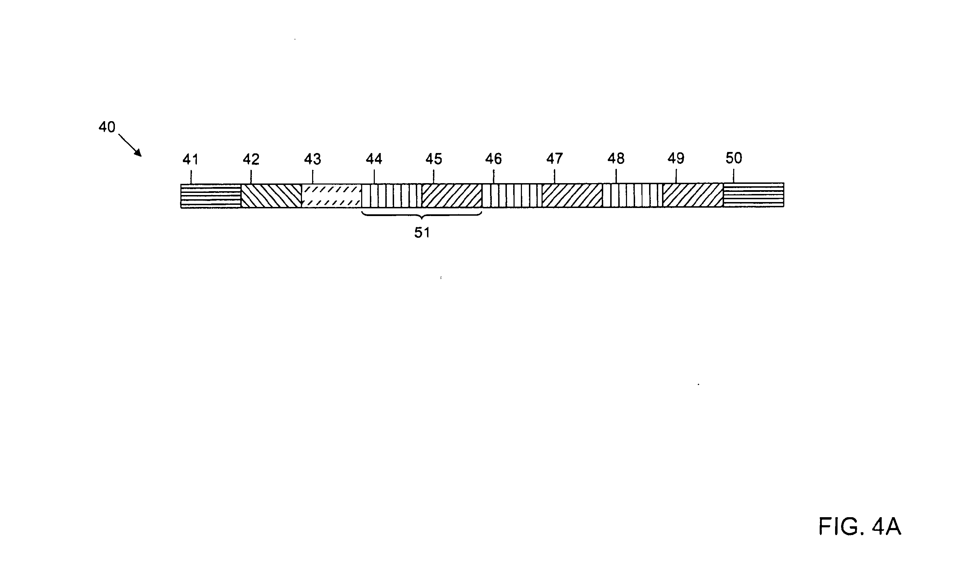

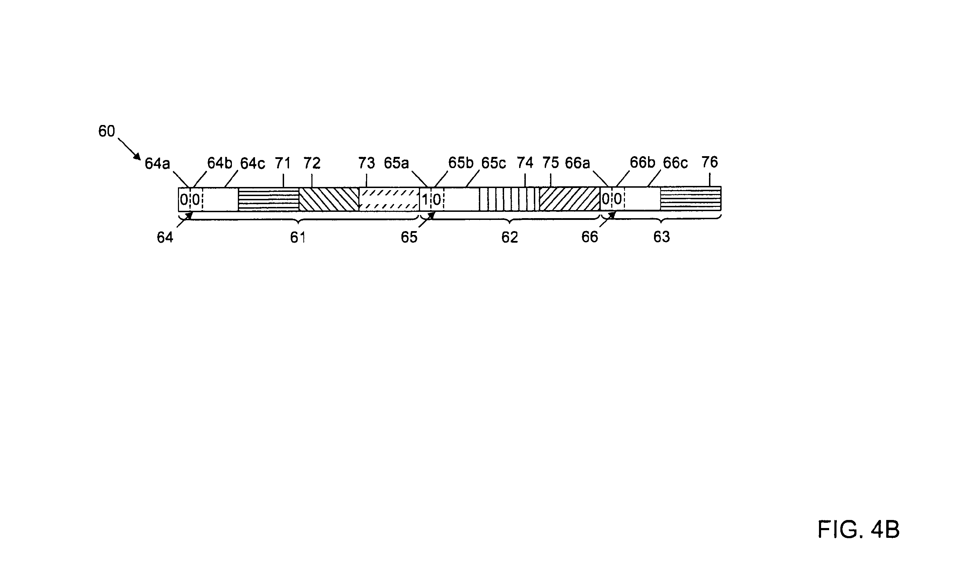

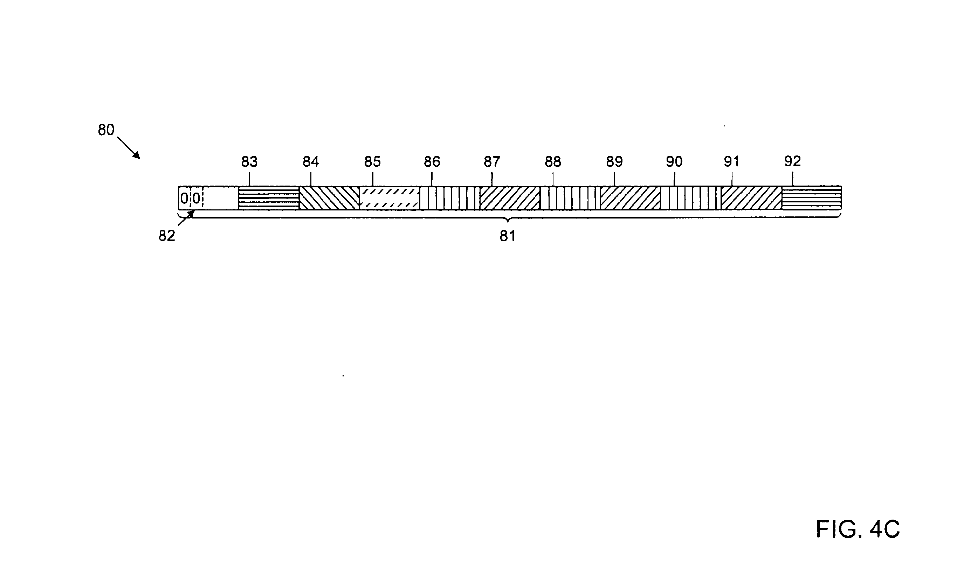

With reference to Figs. 4-6, the data compression method of Fig. 3 will be explained in more detail for exemplary data blocks. Figs. 4-6 include schematic illustrations of data bytes, and different filling patterns correspond to different byte values throughout these figures, while identical filling patterns represent identical byte values. I.e., bytes illustrated with the same pattern have stored therein the same data.

Fig. 4A illustrates a data block 40 comprising bytes 41-50. Bytes 44, 46 and 48 and bytes 45, 47 and 49 are identical, respectively. Bytes 44 and 45 in combination form a data sequence 51 of length two bytes that is repeated successively three times in the data block 40. Bytes 41-43 and byte 50 are respectively different from each one of bytes 44 and 45 in the illustrated exemplary data block 40.

Fig. 4B illustrates a digital data archive 60 generated from the data block 40, which includes data packets 61-63. The digital data archive 60 may, for example, be generated using the data compression method 20 of Fig. 3.

Every data packet 61-63 comprises at least one control byte 64-66 in which the control information and the size information are stored. In the illustrated digital data archive 60, every data packet 61-63 may have a first or a second packet type and may comprise either one or two control bytes, depending on the amount of control information that has to be stored in the control byte(s). The first bit 64a-66a of each control byte 64-66 is a packet type indicator having a value set to 0 or 1, depending on whether the data packet has the first or second packet type, respectively. The second bit 64b-66b of each control byte 64-66 is a size bit set to have value 0 when there is only one control byte in the data packet, and set to have value 1 when there are two control bytes. The remaining six bits 64c-66c of the control byte 64-66 respectively store a counter value which depends on the packet type. For a data packet having the first packet type, the counter value represents the number of bytes that follow in the respective data packet, i.e., the number of bytes of payload data included in the data packet. For a data packet having the second packet type, the counter value represents the number of successive repetitions of the data sequence in the original data. For the illustrated data packets 61-63, the packet type indicator stored in bit 64a-66a and the counter value stored in the remaining six bits 64c-66c, respectively, represent "control information", while the second bit 64b-66b of the control byte 64-66, respectively, has stored therein "size information".

Every data packet 61-63 further comprises payload data. For data packet 61, the payload data includes bytes 71-73 which are copies of bytes 41-43 of the original data, respectively. For data packet 62, the payload data includes bytes 74 and 75, which are copies of bytes 44 and 45 of the original data, i.e., the data sequence 51 is written into the data packet 62 as payload data. For data packet 63, the payload data includes byte 76 which is a copy of byte 50 of the original data.

Next, the generation of the data packets 61-63 from the data block 40 will be explained. For illustration only, it is assumed that the second packet type is selected when the data includes at least three successive repetitions of a data sequence having a length of two bytes, i.e., the predetermined number of repetitions is three, while the data sequence is constrained to have a length of two bytes.

When data is read from the data block 40, the data packet 61 is generated having the first packet type, as bytes 41-43 do not include a repetition of a data sequence. Because there are only three bytes 41-43, the counter value of three can be stored in the six bits 64c of control byte 64, and no second control byte is required. The size bit 64b is set to 0 in order to indicate that there is only one control byte 64 in the data packet 61, and the packet type indicator bit 64a is set to 0 in order to indicate that the data packet 61 has the first packet type. Bytes 41-43 are copied into the data packet 61 as payload data 71-73.

When further data is read from the data block 40, the data packet 65 is generated having the second packet type, as bytes 44-49 include at least three successive repetitions of the data sequence 51. As there are only three successive repetitions of the data sequence 51 in the original data, the counter value of three indicating the number of repetitions can be stored in the six bits 65c of the control byte 65, and no second control byte is required. The size bit 65b is set to 0 in order to indicate that there is only one control byte 65 in the data packet 62, and the packet type indicator bit 65a is set to 1 in order to indicate that the data packet 65 has the second packet type. The data sequence 51 is written into the data packet 62 as payload data 74, 75.

The data packet 63 having the first packet type is generated in essentially the same way as data packet 61, the counter value stored in the six bits 66c being equal to one in order to indicate that the data packet 63 includes only one byte of payload data.

When generating data packets from data retrieved from the data block 40, constraints may be imposed on the data sequence, e.g., on the length of the data sequence, and the resulting generated digital data archive may depend on the imposed constraints.

Fig. 4C schematically illustrates a digital data archive 80 generated from the data block 40 when the length of the data sequence is constrained to be one byte. I.e., data packets having the second packet type are generated when the data retrieved from the data block 40 includes successive repetitions of a one-byte data sequence. As the data block 40 does not include successive repetitions of a one-byte data sequence, a single data packet 81 having the first packet type is generated, as indicated by the control byte 82, the payload data comprising bytes 83-92 which are copies of the original data bytes 41-50. The same applies when the length of the data sequence is constrained to be three or four bytes, for the data block 40 does not include successive repetitions of a three- or four-byte data sequence.

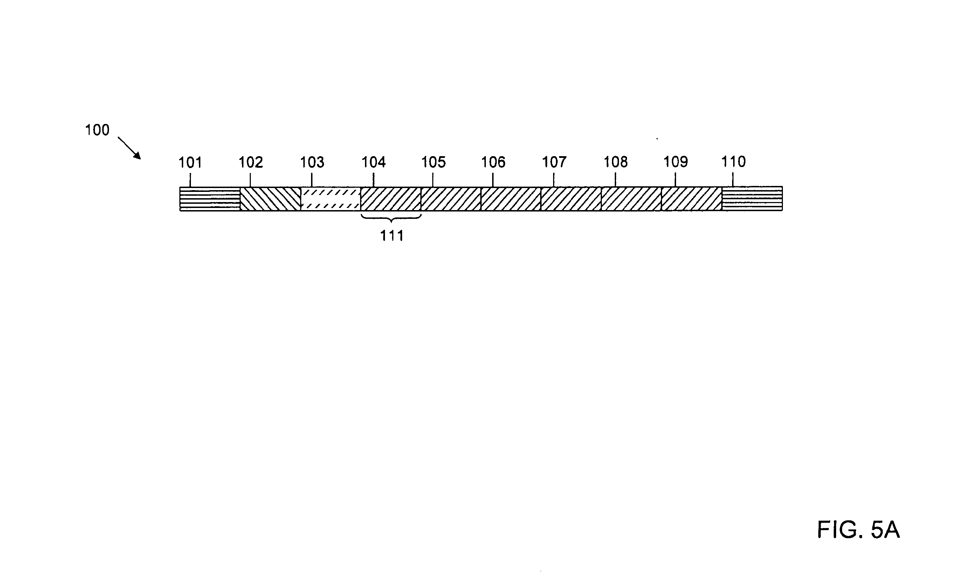

Fig. 5A illustrates a data block 100 comprising bytes 101-110. Bytes 104-109 are identical to each other. Byte 104 represents a data sequence 111 having a length of one byte that is repeated successively six times in the data block 100. Bytes 101-103 and byte 110 are respectively different from bytes 104-109 in the illustrated exemplary data block 100.

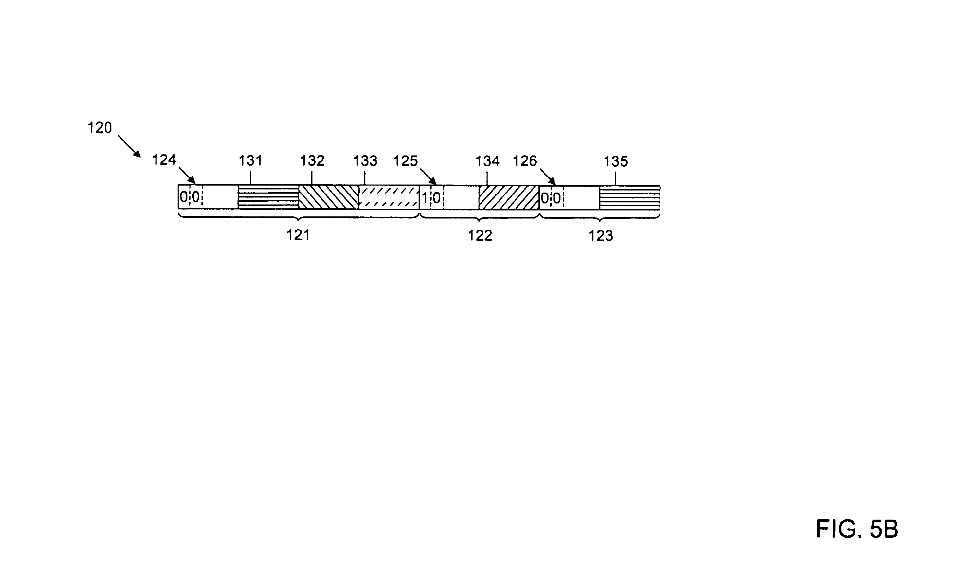

Fig. 5B illustrates a digital data archive 120 generated from the data block 100, which includes data packets 121-123. The digital data archive 120 may, for example, be generated using the data compression method 20 of Fig. 3. Each of the data packets 121-123 includes a control byte 124-126. The structure of the control bytes 124-126 is essentially the same as the one of control bytes 64-66 of Fig. 4B.

The generation of the digital data archive 120 will next be explained assuming that the length of the data sequence is constrained to be one byte, while the predetermined number of repetitions is set to be three. As bytes 101-103 and byte 110 do not include successive repetitions of a specific byte, the data packets 121 and 123 are generated from bytes 101-103 and byte 110, respectively, in the same way as described with reference to Fig. 4B above. As bytes 104-109 include six successive repetitions of the data sequence 111, the data packet 122 has the second packet type, the data sequence 111 being written into the data packet 122 as payload data 134.

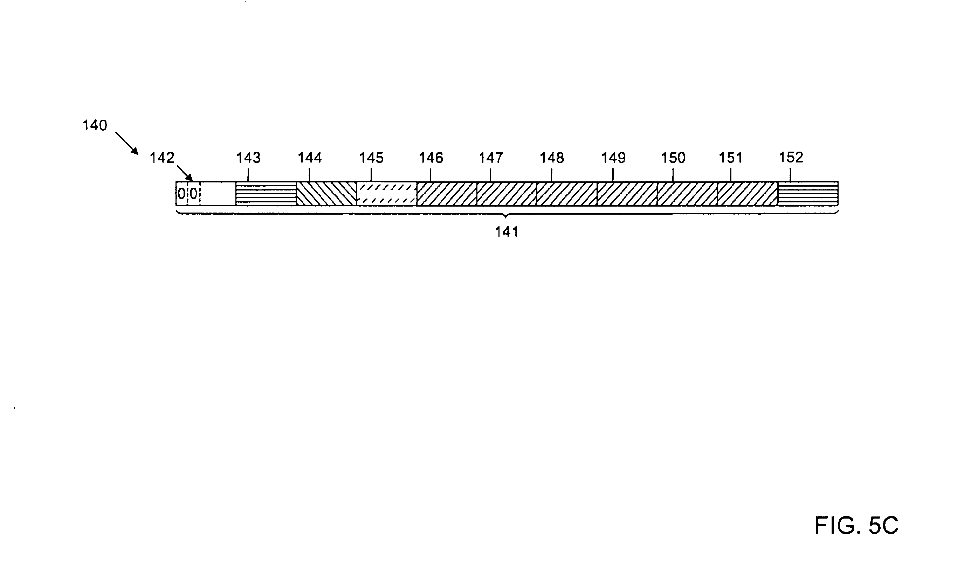

Fig. 5C illustrates a digital data archive 140 generated from the data block 100 when the length of the data sequence is constrained to be, e.g., four bytes. As the data block 100 does not include successive repetitions of a four-byte data sequence, a single data packet 141 having the first packet type is generated in essentially the same manner as described with reference to Fig. 4C above.

For other lengths of the data sequence, the generated data packets depend on the predetermined number of repetitions required for a data packet having the second packet type to be generated. For example, when the length of the data sequence is set to be two bytes and the predetermined number of repetitions is set to be three, a data packet essentially similar to data packet 122 will be generated from bytes 104-109, for the bytes 104-109 include three successive repetitions of a two-byte data sequence formed of bytes 104 and 105. Correspondingly, the two-byte data sequence formed of bytes 104 and 105 is copied into the generated data packet having the second packet type.

While the exemplary data packets of Figs. 4 and 5 respectively comprise only one control byte, data packets may be generated to comprise more than one control byte. The number of control bytes may be selected based on the number of bits required to store the size information and the control information.

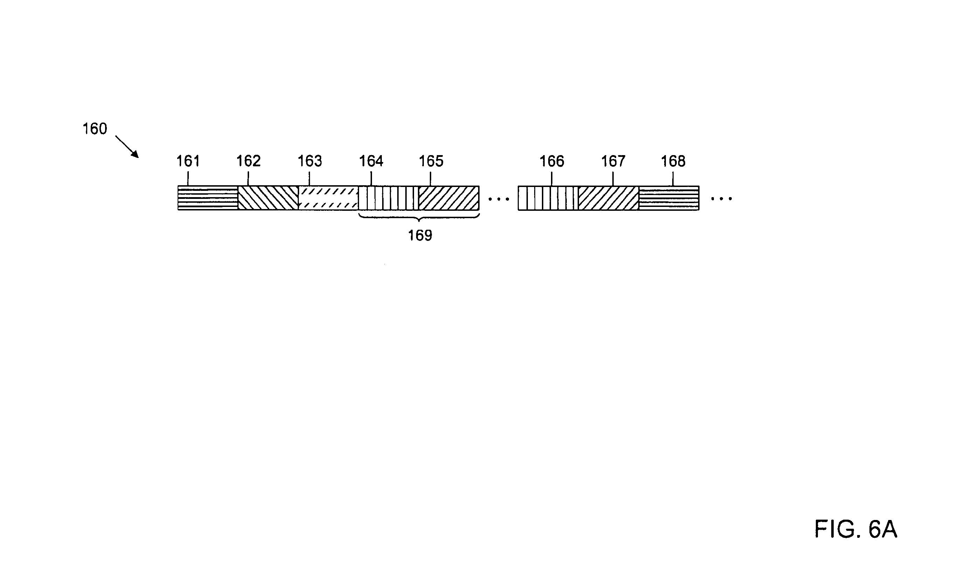

Fig. 6A illustrates a data block 160 comprising bytes 161-168. The data block 160 includes a large number, e.g., more than 63, of successive repetitions of a data sequence 169 formed of bytes 164 and 165, as schematically indicated by dots in Fig. 6A. Similarly, the data block 160 includes a series of bytes starting with byte 168 which comprises more than 63 bytes and does not include successive repetitions of a data sequence.

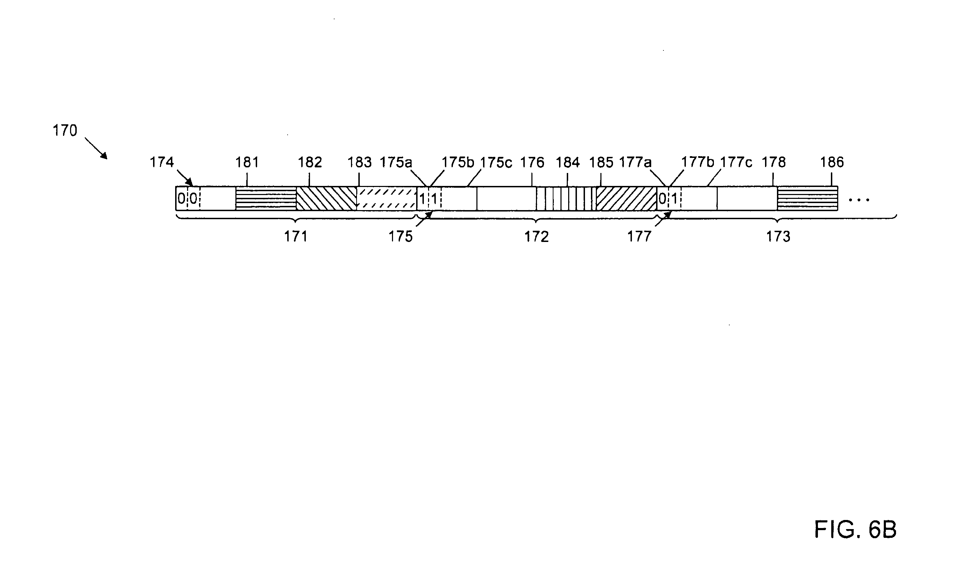

Fig. 6B illustrates a digital data archive 170 generated from the data block 160, which comprises data packets 171-173. Data packet 171 includes one control byte 174 and payload data 181-183 and is generated in the manner described with reference to data packet 61 of Fig. 4B above. As the data comprising bytes 164-167 comprise a large number of successive repetitions of the data sequence 169, the counter value set equal to the number of repetitions cannot be stored in the remaining six bits 175c of control byte 175. Therefore, the data packet 172 is generated so as to comprise a second control byte 176. The size bit 175b of the control byte 175 is set to have value 1 to indicate that there is a second control byte in the data packet 172. The counter value indicating the number of repetitions of the data sequence 169 in the original data is then stored in the remaining six bits 175c of control byte 175 and in control byte 176. The payload data 184, 185 of the data packet 172 corresponds to the data sequence 169. Similarly, the data packet 173 having the first packet type is generated so as to include two control bytes 177, 178 in addition to payload data, as the counter value indicating the data amount of the payload data starting with byte 168 cannot be stored in the six bits 177c of the control byte 177. The size information stored in the size bit 177b indicates that there are two control bytes 177, 178 in the data packet 173.

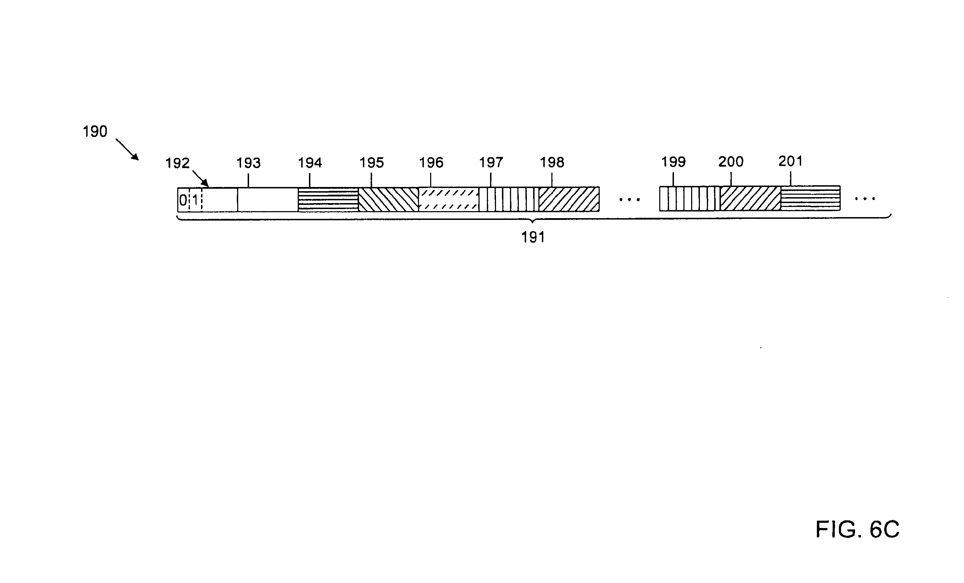

Fig. 6C illustrates a digital data archive 190 generated from the data block 160 when, e.g., the data sequence is constrained to have a length of one byte. As the data block 160 does not include successive repetitions of a one-byte data sequence, a single data packet 191 having the first packet type is generated, which comprises two control bytes 192, 193 and a copy of the original data 161-168 as payload data 194-201.

The generation of exemplary data packets has been explained with reference to Figs. 4-6. It is to be understood that these explanations are provided for illustration only. Various modifications may be made when generating data packets from the original data block. For example, the control information included in the data packet may comprise other information instead of, or in addition to, the packet type indicator and counter value shown in the data packets of Figs. 4-6. E.g., for data packets having the second packet type, the counter value could also be set equal to the number of repetitions of the data sequence minus the predetermined number of repetitions. Further, while the data packets illustrated in Figs. 4-6 only include one or two control bytes, the method may be adapted to accommodate a larger number of control bytes. In this case, a correspondingly larger number of bits of the control bytes may be reserved to store the size information. For example, when one, two or three control bytes are admissible for every data packet, the size information may be stored in two bits of the first control byte.

As has been illustrated above, data packets, although of different types, are generated both when the original data includes the predetermined number of repetitions of a data sequence and when the original data does not include the predetermined number of repetitions of a data sequence. Therefore, the digital data archive formed from the generated data packets can be decompressed efficiently. Further, as the data packets generated from data that does not include the predetermined number of repetitions of a data sequence are allowed to have variable size, problems associated with data alignment, e.g., line alignment when compressing image data, may be reduced. Information on the data amount or size of the respective data packet having the first packet type is included in the data packet as control information.

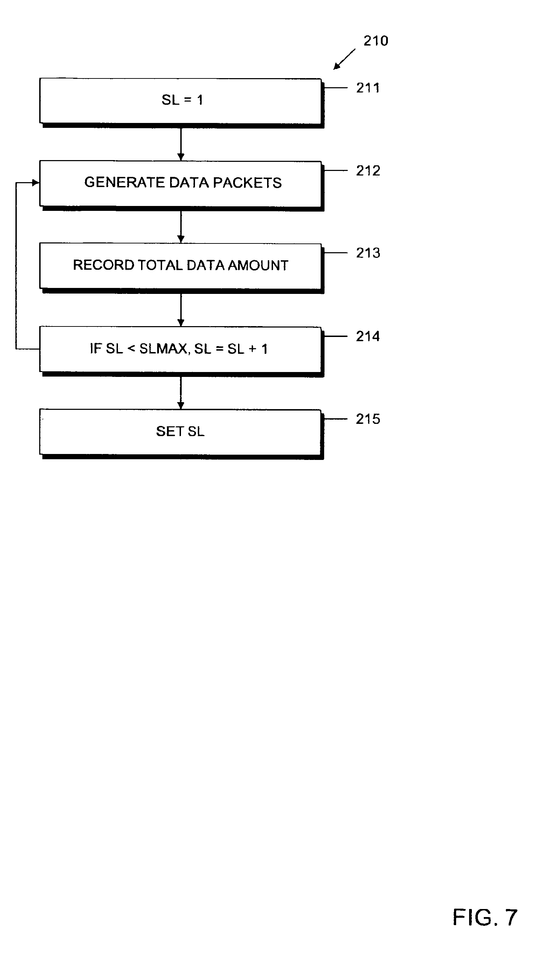

In the data compression method, the generation of data packets from a data block may be repeated several times, with different parameters being used for the respective iteration. For example, when generating data packets, the length of a data sequence may be set to different fixed values when determining the packet type of the data packet, as will be explained with reference to Fig. 7.

Fig. 7 is a flow diagram representation of a data compression method 210 according to an embodiment. At 211, a length of a data sequence sl is set to be one byte. At 212, data packets are generated using any one of the data compression methods described above. For example, data packets of the second type may be generated when data retrieved from a data block comprises a predetermined number of repetitions of a data sequence having length sl, and a data packet having the first packet type may be generated otherwise. As has been explained above, the resulting digital data archive will usually depend on the constraints imposed on the data sequence, such as the length of the data sequence. At 213, the total data amount of the digital data archive generated for the specific value of sl is recorded. At 214, the set length sl of the data sequence is incremented by one byte, and steps 212-214 are repeated using the new length sl. When a maximum value slmax is reached, the data compression method 210 proceeds to step 215. At 215, the different total data amounts recorded at 213 are compared, and the length sl is set to have the value for which the total data amount is minimum.

While not shown in Fig. 7, not only one, but several parameters may be varied when the generation of a digital data archive is repeated. For example, when adjusting the length sl of the data sequence, the predetermined number of repetitions that is required for a data packet having the second packet type to be generated may be adjusted accordingly.

When data compression is performed repeatedly while varying a parameter of the data compression method, the size of the resulting digital data archive may be further optimized. For illustration, when the data block to be compressed corresponds to bitmap image data, one, two, three, four or more bytes of data may be associated with every image pixel, depending on the colour depth. Neighbouring image pixels having identical colours therefore result in repetitions of one-, two-, three-, four- or more-byte sequences in the image data. With the method of Fig. 7, good compression of the image can be achieved even when the colour depth is not known in advance. The same applies to other types of data

The data compression methods described above may be advantageously combined with additional compression or encoding techniques.

According to one embodiment, a method is provided in which an integer value contained in a data block is encoded by adjusting a number of bytes in which the integer value is stored, based on the integer value. Control bits of one of the bytes storing the integer value may be set to indicate the number of bytes in which the integer value is stored.

For illustration, integer values may be encoded in a number of bytes which is allowed to vary from one to five bytes instead of providing a fixed number of, e.g., four bytes for every integer value. When only up to seven bits are required for a binary representation of the integer value, which is the case for unsigned integer values smaller than 128, the integer value is stored in one byte and the first bit of the byte is set to 0 to indicate that the integer is stored in one byte. When more than seven but less than 15 bits are required for a binary representation of the integer value, which is the case for unsigned integer values ranging from 128 to 16.383, the integer value is stored in two bytes and the first two bits of the first byte may be set to 10 to indicate the number of bytes, while a binary representation of the integer value is written into the remaining 14 bits of the two bytes. When more than 14 but less than 22 bits are required for a binary representation of the integer value, which is the case for unsigned integer values ranging from 16.384 to 2.097.151, the integer value is stored in three bytes and the first three bits of the first byte may be set to 110 to indicate the number of bytes, while a binary representation of the integer value is written into the remaining 21 bits of the three bytes. When more than 21 but less than 29 bits are required for a binary representation of the integer value, the integer value is stored in four bytes and the first four bits of the first byte may be set to 1110 to indicate the number of bytes, while a binary representation of the integer value is written into the remaining 28 bits of the four bytes. When more than 28 but less than 36 bits are required for a binary representation of the integer value, the integer value is stored in five bytes and the first five bits of the first byte may be set to 11110 to indicate the number of bytes, while a binary representation of the integer value is written into the remaining 35 bits of the four bytes. By appropriately adjusting the number of bytes storing the integer value, bytes of original data in which all bits are set to 0 are truncated from the representation of the integer value, at the expense of providing the control bits indicating the number of bytes in which the integer value is stored or encoded.

The encoding may be correspondingly applied to signed integer values. For example, a signed integer value from -64 to +63 can be stored in one byte. The first bit of the byte may be a sign flag set to 0 or 1 depending on whether a positive or negative integer value is stored, respectively, the second bit is set to value 0 to indicate that the integer value is encoded in only one byte, and the remaining six bits store the integer value. When the integer value uvalue is negative, not the integer value itself, but -uvalue - 1 is stored in the remaining six bits of the byte, i.e., the negative integer value is mapped to a positive integer value before being written into the remaining six bits of the byte. Similarly, a signed integer value from -8.192 to 8.191 may be stored in two bytes. The first bit of the first byte may again be a sign flag, followed by a bit sequence 10 to indicate that two bytes are required to encode the integer value. Correspondingly, when three bytes are required to encode the integer value, the sign flag is followed by a bit sequence 110, when four bytes are required, the sign flag is followed by a bit sequence 1110, and when five bytes are required, the sign flag is followed by a bit sequence 11110, etc. Thereby, a unique encoding of integer values is implemented.

The encoding method illustrated above is only illustrative. For example, the bits indicating whether the integer value is encoded in one, two, three, four or five bytes, do not need to be included in one single byte, but may be distributed over the bytes in which the integer value is encoded.

Utilizing the above encoding method, small integer values may be efficiently encoded so as to reduce storage space. The illustrated encoding is therefore particularly suitable when a data block includes many small integer values. For example, integer values indicating positions on a display are frequently in a range from 0 to about 1400, depending on the pixel resolution of the display. Therefore, the encoding method may be employed in human-machine interfaces, e.g., for data used in a navigation device in a vehicle. The encoding scheme for integer values may also be applied to the header portion of a bitmap image.

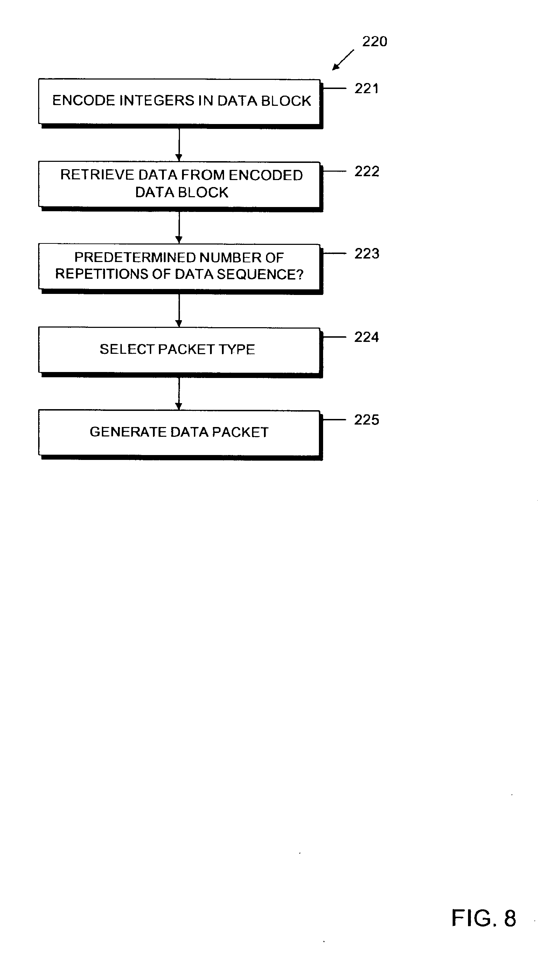

Fig. 8 is a flow diagram representation of a data compression method 220 according to an embodiment. At 221, integer values included in a data block are encoded, for example using the encoding method described above. Thereby, an encoded data block is generated. In one implementation, only integer values included in the header portion of a bitmap image are encoded at 221. At 222-225, data is retrieved from the data block and data packets are generated. Steps 222-225 may be implemented according to any one of the methods described with reference to Figs. 2-7 above. In this manner, a digital data archive is generated.

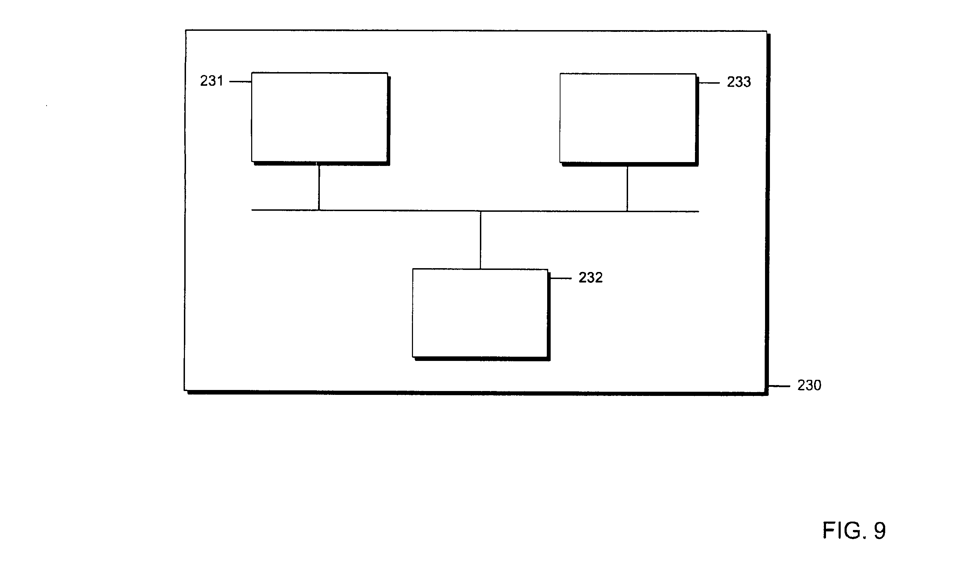

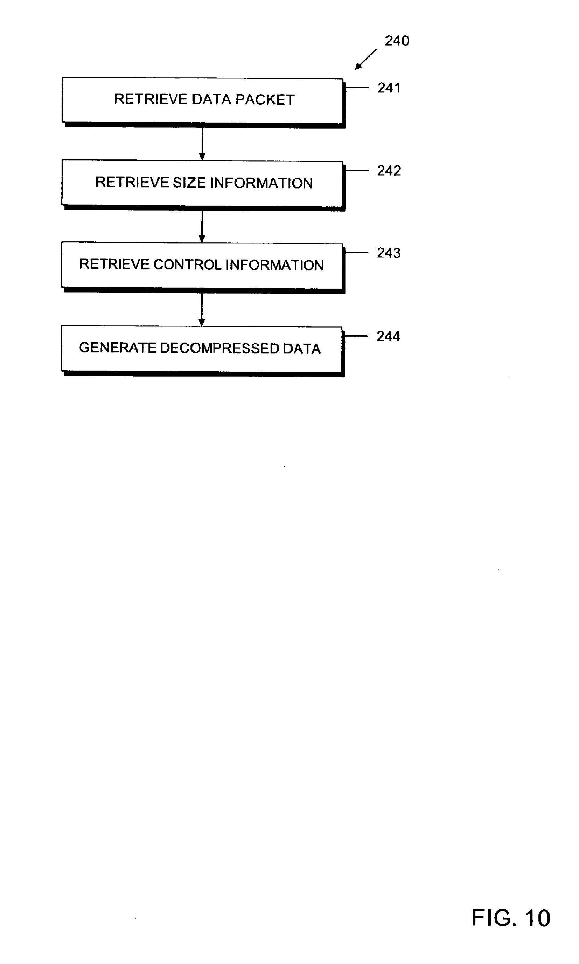

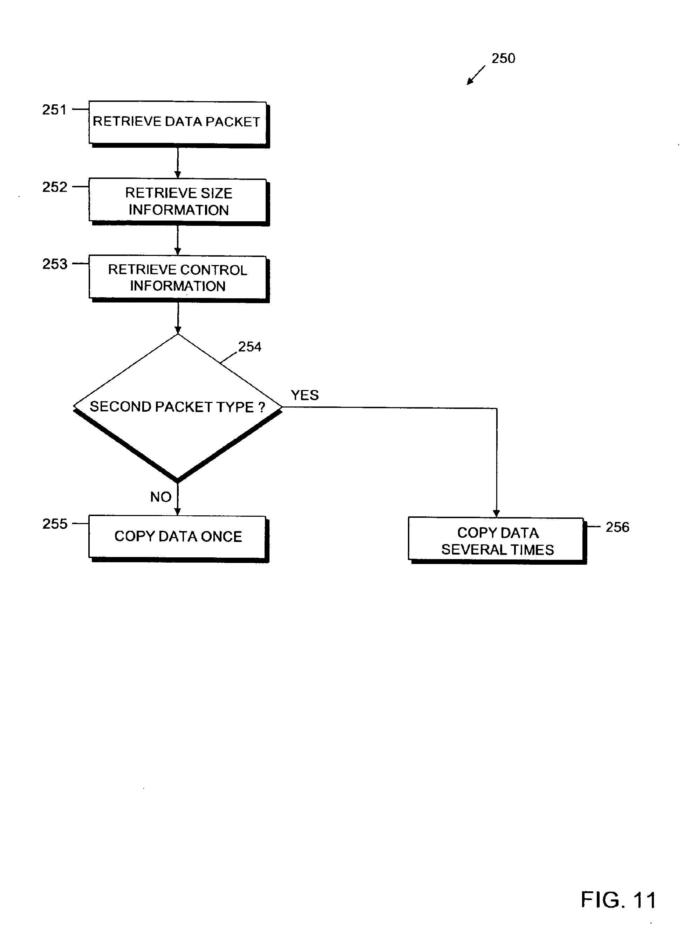

Fig. 9 is a schematic block diagram representation of a navigation device 230. The navigation device 230 may be installed onboard a vehicle. The navigation device 230 comprises a digital data archive 231, a processor 232 coupled to the digital data archive 231 to retrieve data packets from the digital data archive 231, and an output device 233 coupled to the processor 232. The digital data archive 231 may be any suitable storage medium, e.g., a hard disk, a CD-ROM, a DVD, a flash memory, or any other suitable storage device on which compressed data are stored. The data of the digital data archive 231 may be generated utilizing any one of the methods described with reference to Figs. 1-8 above. The processor 232 may be a general purpose processor which is configured, for example using suitable instruction code stored on a storage medium, to perform a data decompression method that will be described with reference to Figs. 10 and 11 below. The output device 233 may be an optical, acoustic or other output device which receives decompressed data from the processor 232 and generates an output signal based on the decompressed data. For example, the output device 233 may be a display, and the decompressed data may be image data that are displayed on the display.

Fig. 10 is a flow diagram representation of a data decompression method 240 according to an embodiment. The data decompression method 240 may be performed by the processor 232 of the navigation device 230 of Fig. 9. At 241, a data packet is retrieved from a digital data archive. The data packet includes control information, size information, and payload data. At 242, the size information is retrieved from the data packet. The size information indicates in which portion of the data packet the control information is stored. For example, the size information may be a size bit indicating whether the control information is stored in one or two bytes of the data packet. At 243, the control information is retrieved from the portion of the data packet indicated by the size information. The control information includes information for decompressing the data packet. At 244, decompressed data is generated from the data packet based on the control information.

The data decompression method 240 will be further illustrated referring back to Fig. 4B and Fig. 6B, respectively. In the exemplary data packets 61-63 and 171-173 of Figs. 4B and 6B, the size information is a size bit 64b, 65b, 66b, 175b, 177b indicating whether there are one or two control bytes in the respective data packet 61-63, 171-173, and the control information includes the packet type indicator stored in bit 64a, 65a, 66a, 175a, 177a and a counter value stored in the remaining bits of the control byte(s). When the data packet 62 is retrieved from a digital data archive, the size information 65b is retrieved from the data packet 62. As the size information 65b set to value 0 indicating that there is just one control byte in the data packet 62, a counter value is read from the remaining six bits 65c of the first byte 65 of the data packet 62 only. Based on the counter value stored in the six bits 65c of the control byte 65 and based on the packet type indicator 65a, decompressed data is generated, as will be explained in more detail with reference to Fig. 11 below. Similarly, when data packet 61 or 63 is retrieved, the control information is read from a single control byte only, as specified by the respective size information 64b or 66b. When data packet 172 of Fig. 6B is retrieved, the size information 175b is retrieved from the data packet 172. As the size information 175b set to value 1 indicating that there are two control bytes in the data packet 172, a counter value is read from the remaining six bits 175c of the first byte 175 of the data packet 172 and from the second byte 176 of the data packet 172. Similarly, when data packet 173 is retrieved, control information is retrieved both from the first byte 177 and from the second byte 178 of the data packet 177, as indicated by the size information 177b.

Fig. 11 is a flow diagram representation of a data decompression method 250 according to an embodiment. For illustration, it is assumed that data packets may have a first packet type or a second packet type. At 251-253, a data packet is retrieved from a digital data archive and size information and control information is retrieved from the data packet. These steps may be implemented as described with reference to Fig. 10 above. At 254, it is determined whether the data packet has the first or second packet type, based on the control information retrieved at 253. If the data packet has the first packet type, the method 250 proceed to step 255. Payload data included in the data packet is then copied once to the decompressed data in order to generate the decompressed data. If the data packet has the second packet type, the method 250 proceed to step 256. Payload data included in the data packet is then copied several times to the decompressed data in order to generate the decompressed data. The number of copies may be determined based on the control information.

Steps 255 and 256, respectively, of the data decompression method 250 will be explained in more detail with reference to the exemplary data packets 171-173 of Fig. 6B. When the data packet 171 having the first packet type is retrieved, the payload data 181-183 is copied once to the decompressed data. The amount of payload data, i.e., the size of the data packet, is indicated by the counter value stored in the control byte 174. Subsequently, when the data packet 172 having the second packet type is retrieved, the payload data 184, 185 is copied several times to the decompressed data. The number of copies of the payload data 184, 185 in the decompressed data is specified by the counter value stored in the control bytes 175, 176. Subsequently, when the data packet 173 having the first packet type is retrieved, the payload data 186 is copied once to the decompressed data. In this manner, the original data block 160 is generated from the data packets 171-173.

Various modifications of the methods and devices illustrated herein may be implemented in other embodiments. For example, when integer values are encoded when generating the data packets, a corresponding decoding of the encoded integer values may be performed when generating decompressed data. Further, while the steps of retrieving data packets and size information have been illustrated as separate steps in some of the embodiments, these steps may be combined as appropriate. While two different packet types have been employed in some of the methods and devices illustrated above, a larger number of different packet types may be implemented, when appropriate for the specific contemplated field of application. While exemplary data packets were shown to include one or two control bytes, data packets may also include more than two control bytes. The size information may also be stored in several bits, when required.

While it is expected that embodiments of the present invention may be advantageously utilized in human-machine interfaces, e.g. of a navigation device, the present invention is not limited to this specific field of application.

## Claims

1. Data compression method, comprising retrieving data from a data block (5; 40; 100; 160) to be compressed,
determining whether the data includes a predetermined number of repetitions of a data sequence (51; 111; 169),
selecting a packet type from a plurality of packet types for said data based on said determining, and
generating a data packet (61-63; 81; 121-123; 141; 171-173; 191) from said data (40; 100; 160), said data packet (61-63; 81; 121-123; 141; 171-173; 191) including control information (64a, 64c; 65a, 65c; 66a, 66c; 175a,
175c, 176; 177a, 177c, 178) which is set based on said selected packet type and size information (64b; 65b; 66b; 175b; 177b) which is set based on a storage space containing said control information.

2. The method according to claim 1,
wherein said packet type is selected to be a first packet type when said data
(41-43, 50; 101-103, 110; 161-163; 168) does not include said predetermined number of repetitions of a data sequence (51; 111; 169),
wherein a copy of said data (71-73, 76; 83-92; 131-133, 135; 143-152; 181-183, 186; 194-201) is included in said data packet (61, 63; 81; 121, 123; 141; 171, 173; 191), and the control information is set to include information (64c, 66c; 177c, 178; 192, 193) on a data amount of said data (41-43, 50; 101-103, 110; 161-163; 168).

3. The method according to any one of the preceding claims,
wherein said packet type is selected to be a second packet type when said data (44-49; 104-109; 164-167) includes said predetermined number of repetitions of a data sequence (51; 111; 169),
wherein said data sequence (51; 111; 169) is included in said data packet (62; 122; 172), and the control information is set to include information (65c;
175c, 176) on a number of repetitions of said data sequence (51; 111; 169) in said data (44-49; 104-109; 164-167).

4. The method according to any one of the preceding claims,
wherein said data packet (61-63; 81; 121-123; 141; 171-173; 191) includes at least one control byte (64-66; 82; 124-126; 142; 174-178; 192, 193) which
comprises said control information and said size information, wherein said size information (64b; 65b; 66b; 175b; 177b) is set based on a number of bytes of said at least one control byte (64-66; 82; 124-126; 142; 174-178; 192, 193).

5. The method according to any one of the preceding claims,
wherein said control information (64a, 64c; 65a, 65c; 66a, 66c; 175a, 175c,
176; 177a, 177c, 178) comprises information for decompressing said data packet (61-63; 81; 121-123; 141; 171-173; 191).

6. The method according to any one of the preceding claims, comprising
selecting a length of said data sequence (51; 111; 169) so that a total data amount of generated data packets is minimum.

7. The method according to any one of the preceding claims, comprising
encoding an integer value included in said data block by adjusting a number of bytes storing said integer value based on said integer value.

8. The method according to claim 7, comprising
setting at least one control bit of at least one byte in which said integer value is encoded based on said number of bytes.

9. The method according to any one of the preceding claims,
wherein said data block comprises image data.

10. Data decompression method, comprising
retrieving a data packet (61-63; 81; 121-123; 141; 171-173; 191) which includes control information and size information, said data packet (61-63; 81; 121-123; 141; 171-173; 191) having a packet type selected from a plurality of packet types, and said control information (64a, 64c; 65a, 65c; 66a, 66c; 175a, 175c, 176; 177a, 177c, 178) being based on said packet type,
retrieving said size information (64b; 65b; 66b; 175b; 177b) from said data packet (61-63; 81; 121-123; 141; 171-173; 191),
retrieving said control information (64a, 64c; 65a, 65c; 66a, 66c; 175a, 175c, 176; 177a, 177c, 178) from said data packet (61-63; 81; 121-123; 141; 171-173; 191), wherein a portion of said data packet from which the control information is retrieved is determined based on said size information (64b; 65b; 66b; 175b; 177b), and
generating decompressed data from said data packet (61-63; 81; 121-123; 141; 171-173; 191) based on said control information (64a, 64c; 65a, 65c; 66a, 66c; 175a, 175c, 176; 177a, 177c, 178).

11. The method according to claim 10, comprising
copying data (71-76; 83-92; 131-135; 143-152; 181-186; 194-201) from said data packet (61-63; 81; 121-123; 141; 171-173; 191) to generate said decompressed data, wherein a number of copies of said data (71-76; 83-92; 131-135; 143-152; 181-186; 194-201) from said data packet (61-63; 81; 121-123; 141; 171-173; 191) in said decompressed data is set based on said control information (64a, 64c; 65a, 65c; 66a, 66c; 175a, 175c, 176; 177a, 177c, 178).

12. The method according to claim 11,
wherein said data (71-73, 76; 83-92; 131-133, 135; 143-152; 181-183, 186; 194-201) from said data packet (61, 63; 81; 121; 123; 141; 171, 173; 191) is copied once to said decompressed data when said data packet (61, 63; 81; 121; 123; 141; 171, 173; 191) has a first packet type, and wherein said data (74, 75; 134; 184, 185) from said data packet (62; 122; 172) is copied plural times to said decompressed data when said data packet (62; 122; 172) has a second packet type.

13. The method according to any one of claims 10-12, comprising
determining a data amount contained in said data packet (61, 63; 81; 121, 123; 141; 171, 173; 191) based on said control information (64a, 64c; 66a, 66c; 177a, 177c, 178).

14. The method according to any one of claims 10-13,
wherein said data packet (61-63; 81; 121-123; 141; 171-173; 191) includes
at least one control byte (64-66; 82; 124-126; 142; 174-178; 192, 193) which comprises said control information and said size information, said size information (64b; 65b; 66b; 175b; 177b) indicating a number of bytes of said at least one control byte (64-66; 82; 124-124; 142; 174-178; 192, 193).

15. The method according to any one of claims 10-14, comprising
decoding an encoded integer value included in said decompressed data based on at least one control bit of at least one byte storing said encoded integer value, wherein a number of bytes of said at least one byte storing said encoded integer value is determined based on said at least one control bit.

16. The method according to any one of claims 10-15,
wherein said data packet is retrieved from a digital data archive (231) for use in a human-machine-interface, in particular of a navigation system (230).

17. Data storage device,
having stored thereon instructions which, when executed by a processor (232) of an electronic computing device (231, 232), direct the processor (232) to perform the method according to any one of claims 10-16.

18. Data processing apparatus, comprising
a digital data archive (231) storing a data packet (61-63; 81; 121-123; 141; 171-173; 191) which includes control information (64a, 64c; 65a, 65c; 66a, 66c; 175a, 175c, 176; 177a, 177c, 178) and size information (64b; 65b; 66b; 175b; 177b), said data packet (61-63; 81; 121-123; 141; 171-173; 191) having a packet type selected from a plurality of packet types, and said control information being based on said packet type, and
a processor (232) coupled to said digital data archive (231) to retrieve said data packet (61-63; 81; 121-123; 141; 171-173; 191) therefrom, wherein the processor (232) is configured to retrieve said control information (64a, 64c; 65a, 65c; 66a, 66c; 175a, 175c, 176; 177a, 177c, 178) from a portion of said data packet (61-63; 81; 121-123; 141; 171-173; 191) determined based on said size information (64b; 65b; 66b; 175b; 177b), and to generate decompressed data from said data packet (61-63; 81; 121-123; 141; 171-173; 191) based on said control information (64a, 64c; 65a, 65c; 66a, 66c; 175a, 175c, 176; 177a, 177c, 178).

19. Data processing apparatus according to claim 18,
wherein the processor (232) is adapted to perform the method according to any one of claims 10-16.

20. Navigation device, comprising
the data processing apparatus (231, 232) according to claim 18 or claim 19, and
an output device (233) coupled to said processor (232) to receive said decompressed data therefrom and to generate an output signal based on the decompressed data.

## Amended claims

### Amended claims in accordance with Rule 137(2) EPC.

**1.** Data compression method, comprising
retrieving data from a data block (5; 40; 100; 160) to be compressed,
determining whether the data includes a predetermined number of repetitions of a data sequence (51; 111; 169),
selecting a packet type from a plurality of packet types for said data based on said determining, and
generating a data packet (61-63; 81; 121-123; 141; 171-173; 191) from said data (40; 100; 160), said data packet (61-63; 81; 121-123; 141; 171-173; 191) including control information (64a, 64c; 65a, 65c; 66a, 66c; 175a, 175c, 176; 177a, 177c, 178) which is set based on said selected packet type
**characterized in that** said generated data packet includes size information (64b; 65b; 66b; 175b; 177b) which is set based on a storage space containing said control information,
wherein said data packet (61-63; 81; 121-123; 141; 171-173; 191) includes at least one control byte (64-66; 82; 124-126; 142; 174-178; 192, 193) which comprises said control information and said size information, wherein said size information (64b; 65b; 66b; 175b; 177b) is set based on a number of bytes of said at least one control byte (64-66; 82; 124-126; 142; 174-178; 192,193).

**2.** The method according to claim 1,
wherein said packet type is selected to be a first packet type when said data (41-43, 50; 101-103, 110; 161-163; 168) does not include said predetermined number of repetitions of a data sequence (51; 111; 169),
wherein a copy of said data (71-73, 76; 83-92; 131-133, 135; 143-152; 181-183, 186; 194-201) is included in said data packet (61, 63; 81; 121, 123; 141; 171, 173; 191), and the control information is set to include information (64c, 66c; 177c, 178; 192, 193) on a data amount of said data (41-43, 50; 101-103, 110; 161-163; 168).

**3.** The method according to any one of the preceding claims,
wherein said packet type is selected to be a second packet type when said data (44-49; 104-109; 164-167) includes said predetermined number of repetitions of a data sequence (51; 111; 169),
wherein said data sequence (51; 111; 169) is included in said data packet (62; 122; 172), and the control information is set to include information (65c; 175c, 176) on a number of repetitions of said data sequence (51; 111; 169) in said data (44-49; 104-109; 164-167).

**4.** The method according to any one of the preceding claims,
wherein said control information (64a, 64c; 65a, 65c; 66a, 66c; 175a, 175c, 176; 177a, 177c, 178) comprises information for decompressing said data packet (61-63; 81; 121-123; 141; 171-173; 191).

**5.** The method according to any one of the preceding claims, comprising
selecting a length of said data sequence (51; 111; 169) so that a total data amount of generated data packets is minimum.

**6.** The method according to any one of the preceding claims, comprising
encoding an integer value included in said data block by adjusting a number of bytes storing said integer value based on said integer value.

**7.** The method according to claim 6, comprising
setting at least one control bit of at least one byte in which said integer value is encoded based on said number of bytes.

**8.** The method according to any one of the preceding claims,
wherein said data block comprises image data.

**9.** Data decompression method, comprising
retrieving a data packet (61-63; 81; 121-123; 141; 171-173; 191) which includes control information and size information, said data packet (61-63; 81; 121-123; 141; 171-173; 191) having a packet type selected from a plurality of packet types, and said control
information (64a, 64c; 65a, 65c; 66a, 66c; 175a, 175c, 176; 177a, 177c, 178) being based on said packet type,
retrieving said control information (64a, 64c; 65a, 65c; 66a, 66c; 175a, 175c, 176; 177a, 177c, 178) from said data packet (61-63; 81; 121-123; 141; 171-173; 191), and
generating decompressed data from said data packet (61-63; 81; 121-123; 141; 171-173; 191) based on said control information (64a, 64c; 65a, 65c; 66a, 66c; 175a, 175c, 176; 177a, 177c, 178),
**characterized in that**
said data packet (61-63; 81; 121-123; 141; 171-173; 191) includes at least one control byte (64-66; 82; 124-126; 142; 174-178; 192, 193) which comprises said control information and said size information, said size information (64b; 65b; 66b; 175b; 177b) indicating a number of bytes of said at least one control byte (64-66; 82; 124-124; 142; 174-178; 192,193), and
that said method comprises retrieving said size information (64b; 65b; 66b; 175b; 177b) from said data packet (61-63; 81; 121-123; 141; 171-173; 191), wherein a portion of said data packet from which the control information is retrieved is determined based on said size information (64b; 65b; 66b; 175b; 177b).

**10.** The method according to claim 9, comprising
copying data (71-76; 83-92; 131-135; 143-152; 181-186; 194-201) from said data packet (61-63; 81; 121-123; 141; 171-173; 191) to generate said decompressed data,
wherein a number of copies of said data (71-76; 83-92; 131-135; 143-152; 181-186; 194-201) from said data packet (61-63; 81; 121-123; 141; 171-173; 191) in said decompressed data is set based on said control information (64a, 64c; 65a, 65c; 66a, 66c; 175a, 175c, 176; 177a,177c, 178).

**11.** The method according to claim 10,
wherein said data (71-73, 76; 83-92; 131-133, 135; 143-152; 181-183, 186; 194-201) from said data packet (61, 63; 81; 121; 123; 141; 171, 173; 191) is copied once to said decompressed data when said data packet (61, 63; 81; 121; 123; 141; 171, 73; 191) has a first packet type, and wherein said data (74, 75; 134; 184, 185) from said data packet (62; 122; 172) is copied plural times to said decompressed data when said data packet (62; 122; 172) has a second packet type.

**12.** The method according to any one of claims 9-11, comprising
determining a data amount contained in said data packet (61, 63; 81; 121, 123; 141; 171, 173; 191) based on said control information (64a, 64c; 66a, 66c; 177a, 177c, 178).

**13.** The method according to any one of claims 9-12, comprising
decoding an encoded integer value included in said decompressed data based on at least one control bit of at least one byte storing said encoded integer value, wherein a number of bytes of said at least one byte storing said encoded integer value is determined based on said at least one control bit.

**14.** The method according to any one of claims 9-13,
wherein said data packet is retrieved from a digital data archive (231) for use in a human-machine-interface, in particular of a navigation system (230).

**15.** Data storage device,
having stored thereon instructions which, when executed by a processor (232) of an electronic computing device (231, 232), direct the processor (232) to perform the method according to any one of claims 9-14.

**16.** Data processing apparatus, comprising
a digital data archive (231) storing a data packet (61-63; 81; 121-123; 141; 171-173; 191) which includes control information (64a, 64c; 65a, 65c; 66a, 66c; 175a, 175c, 176; 177a, 177c, 178) and size information (64b; 65b; 66b; 175b; 177b), said data packet (61-63; 81; 121-123; 141; 171-173; 191) having a packet type selected from a plurality of packet types, and said control information being based on said packet type, and
a processor (232) coupled to said digital data archive (231) to retrieve said data packet (61-63; 81; 121-123; 141; 171-173; 191) therefrom, wherein the processor (232) is configured to retrieve said control information (64a, 64c; 65a, 65c; 66a, 66c; 175a, 175c, 176; 177a, 177c, 178) from said data packet (61-63; 81; 121-123; 141; 171-173; 191), and to generate decompressed data from said data packet (61-63; 81; 121-123; 141; 171-173; 191) based on said control information (64a, 64c; 65a, 65c; 66a, 66c; 175a, 175c, 176; 177a, 177c, 178),
**characterized in that**
said data packet (61-63; 81; 121-123; 141; 171-173; 191) includes at least one control byte (64-66; 82; 124-126; 142; 174-178; 192, 193) which comprises said control information and said size information, said size information (64b; 65b; 66b; 175b; 177b) indicating a number of bytes of said at least one control byte (64-66; 82; 124-124; 142; 174-178; 192, 193), and
that the processor is configured to retrieve said control information (64a, 64c; 65a, 65c; 66a, 66c; 175a, 175c; 176; 177a, 177c; 178) from a portion of said data packet determined based on said size information (64b; 65b; 66b; 175b; 177b).

**17.** Data processing apparatus according to claim 16,
wherein the processor (232) is adapted to perform the method according to any one of claims 9-14.

**18.** Navigation device, comprising
the data processing apparatus (231, 232) according to claim 16 or claim 17, and
an output device (233) coupled to said processor (232) to receive said decompressed data therefrom and to generate an output signal based on the decompressed data.
